# EUROPEAN PATENT SPECIFICATION

(11) **EP 1 349 967 B1**
(45) Date of publication and mention of the grant of the patent: **03.11.2004**
(21) Application number: 01998670.2
(22) Date of filing: 27.11.2001
(51) Int. Cl.: C23C 14/04, C23C 14/20, C23C 14/58, B41M 1/30, B41M 3/00

(54) **PROCESS FOR THE PREPARATION OF PRINTED AND PARTIALLY METALIZED PLASTIC FILMS**
VERFAHREN ZUR HERSTELLUNG VON BEDRUCKTEN UND TEILWEISE METALLISIERTEN KUNSTSTOFFOLIEN
PROCEDE DE PREPARATION DE FILMS PLASTIQUES IMPRIMES ET PARTIELLEMENT METALLISES

(30) Priority: 29.11.2000 IT MI20002577
(43) Date of publication of application: 08.10.2003
(73) Proprietor: Mipa S.p.a., 61100 Pesaro (IT)
(72) Inventor: PIERETTI, Simona, I-61034 Fossombrone (IT)
(74) Representative: Gervasi, Gemma, Dr.
(86) International application number: PCT/EP2001/013771
(87) International publication number: WO 2002/044439

(56) References cited:
- EP-A- 0 413 819
- EP-A- 0 439 092
- US-A- 3 935 334
- US-A- 4 242 378
- US-A- 4 507 352
- US-A- 4 687 680
- PATENT ABSTRACTS OF JAPAN vol. 015, no. 345 (C-0864), 3 September 1991 (1991-09-03) & JP 03 134154 A (TOPPAN PRINTING CO LTD), 7 June 1991 (1991-06-07)
- PATENT ABSTRACTS OF JAPAN vol. 006, no. 127 (C-113), 13 July 1982 (1982-07-13) & JP 57 054267 A (DAINIPPON PRINTING CO LTD), 31 March 1982 (1982-03-31)

## Description

### FIELD OF THE INVENTION

The present invention refers to a process for the preparation of printed and partially metalized plastic films.

### PRIOR ART

The deposition of a thin aluminium layer on printed plastic films (metalization) is a known process and it is used either to improve the barrier properties of the plastic films or to give a particular optical aspect to the films and to the wraps realized with the obtained films.

In certain instances it is desirable to limit the metalization to defined zones of the film and, in such a case, the metalization process may be carried out upon application on specific areas of a detaching resin which at the end of the process is removed obtaining the partially metalized film (JP 59109529; AN 1984 - 192378 [31] WPINDEX).

Another commonly applied method consists in the use of shaped masks which, not allowing the passage of the metal during the process of under vacuum metalization, limit the deposit to the interest zone. These methods however do not allow to reach high precision levels and therefore they do not allow the "set metalization", that is with metal deposition on the interest zone with a precision equal to 2 tenths of millimeter.

This precision level is on the contrary essential in the films for printed wraps when one wants to metalize, for example, only the printed zone or, for example, to leave a transparent window on the wrap to allow the vision of the contents.

A system used until now for this purpose consists in printing, by zone and by materials resistant to the chemical attacks, a metalized film and in subsequently removing the metal from the unprotected areas by treatment with aqueous solutions containing acids or alkali.

Examples of this process are found in CA 385735, US 4552614, BR 8800032 Patents.

However this system is only applicable on the wraps requiring the printing on the film side external with respect to the wrap contents and generate products having not excellent optical characteristics. In particular the printed zone turns out to be not much brilliant, while the transparent zone is made opaque by the aggressive agents used to remove the metal.

On the contrary, the JP 57018735 patent (Ch. Abstr. 96:218959) provides for metalization by zone on intemally printed films by zone printing with inks containing cross-linking agents able to react with a paint which is subsequently applied on the whole surface of the printed side of the film.

The reaction between inks and paint assures the clutching of the latter on the printed zones while the direct anchoring on the film remains precarious and such that, after the metalization, an appropriate washing with water removes the paint and, with it, the metal from the not printed areas.

This process did not have practical consequence in that, needing a paint layer between ink and metal, it nullifies the metallic brightness effect of the colours which is the desired graphical goal.

US3,935,334 describes a process for providing a margin in a metallised resin film for a condenser element which is characterised by providing on a dielectric resinous layer a water soluble coating layer having a pattern corresponding to a margin pattern, providing a metal deposition layer on the resinous layer including a coated part and removing the water soluble coating layer and the metal deposition layer thereon by washing with water.

US4,242,378 discloses a method of making a decorated film with a metal layer in the form of a given pattern comprising the steps of forming a metal layer on at least one surface of a base sheet. When a water soluble resin is used, the resin is printed on the base sheet to form a negative resinous pattern and then the metal layer is formed on the surface with the resinous pattern. The resultant material is immersed in water to dissolve the resin and simultaneously remove the metal coated on the resinous pattern together with the resin.

US4,687,680 discloses a stamping foil which comprises a flexible supporting web, a lubricating layer provided on substantially whole one surface of the supporting web, a coloured water resistant resinous layer having a desired pattern provided on the lubricating layer and an adhesive layer provided in manner that all of the exposed surfaces of the lubricating layer, of the coloured water resistant resinous layer and or of the metal deposition layer are covered by the adhesive layer.

EP413819A1 discloses a transfer material with a pattern of metallic gloss comprising a base sheet, having provided thereon in order: a release layer, a think-film metallic layer and a pattern forming adhesive layer, containing a thermosetting resin and an extender pigment. This transfer material is produced by dissolving away the metallic layer not covered by the adhesive layer with an aqueous alkali or acid solution, and providing a coloured adhesive in the release layer to form a pattern. Alternatively, the transfer material may also be produced by partly providing a water soluble resin layer under the metallic layer , partly dissolving away the metallic layer by washing with water, and providing the adhesive layer on the metallic layer to form a pattern.

Then the partial metalization of films printed on the internal side of the wrap was not until now realizable with satisfying qualitative results, particularly from the graphical point of view.

Moreover, the processes until now known, requiring the application of the detaching paint on the whole surface of the film and its detachment by washing only from the not printed zones, imply the presence of the metal only and exclusively where the inks are and, therefore, they do not allow to obtain wraps carrying metalized zones directly on the film or wraps carrying printed zones without the metal standing above.

### SUMMARY

Now we have found that, using a water-soluble paint "set" applied with high precision in determined zones of a printed plastic film, metalizing the film and subsequently washing with water, partially metalized films having graphics of high quality unreachable by the methods known until now, are obtained.

The process for the preparation of a printed and partially metalized plastic films according to the present invention, comprises the following steps:
A) the film is printed with inks by a rotogravure machine;
B) to definite zones of the printed plastic film a water-soluble paint is applied by a rotogravure printing machine keeping the paint "set", with a precision equal to two tenths of millimeter, with the inks themselves;
C) the so obtained plastic film is metalized by a under vacuum process, depositing a thin aluminium layer on the whole surface of the printed side of the film;
D) the metalized film is washed by water in order to remove the water-soluble paint and, with it, the metal deposited on it.

Said process allows to obtain a brilliance and a metallic aspect of the inks not obtainable with the existing technologies.

Moreover, the specific application conditions of the water-soluble paint allow to obtain transparent windows having a high light transmission.

In addition to the evident graphical advantages, the present invention allows to produce films for wraps also having, besides zones printed by the above standing metal:
- zones metalized with metal directly applied on the film,
- not metalized printed zones, and
- transparent zones.

### DESCRIPTION OF THE INVENTION

The invention relates to a process for the preparation of printed and partially metalized plastic films and to the monofilm and coupled wraps obtained from them.

Examples of plastic films usable in the present invention include polypropylene, bioriented, co-extruded or lacquered polypropylene, polyester and polyamide and preferably polypropylene and more preferably lacquered polypropylene.

The process comprises the following steps:
A) the film is printed with inks by a rotogravure machine;
B) by a rotogravure printing machine a water-soluble paint is applied in the desired areas of the printed plastic film.
   The spreading of the paint is carried out on line, immediately after the printing of the inks, keeping the paint "set", with a precision of two tenths of millimeter, with the inks themselves;
C) the so obtained plastic film is metalized by an under vacuum process, depositing a thin aluminum layer on the whole surface of the printed side of the film;
D) the metalized film is washed with water in order to remove the water-soluble paint and, with it, the metal deposited on it.

By the process of the present invention, suitably modulating the application zones of the inks and the water soluble paint, one may obtain films carrying areas printed with inks, areas printed with inks carrying a metallic layer on them, metalized areas with metal directly applied on the film and transparent areas. The films showing, together with the other areas, also transparent areas are preferred.

By the process of the present invention, for example, one may obtain printed wraps having the characteristic to carry a metallic layer on the inks and, at same time, transparent "windows" allowing to see the wrap contents.

The areas where the inks carry an above standing metallic layer show particularly brilliant and extraordinary metallic aspect colours, therefore producing graphics having a qualitative level never reached with the techniques known until now.

Moreover the transparent zones show a light transmission level never reached with the processes until now known, particularly in the case of lacquered plastic films.

The inks used in the step A) are those ones used in the known technique of rotogravure printing.

The water-soluble paint used in the step B) is a paint containing polyvinyl pyrrolidone in an alcoholic solvent, having dry residue ranging from 32 to 36% and viscosity between 52" and 58" (Ford Cup 4). The alcoholic solvent may be methanol, ethanol or isopropanol, preferably ethanol. The paint is taken to the viscosity needed to the printing process by dilution with an alcohol having low molecular weight such as methanol, ethanol or isopropanol, preferably ethanol.

The viscosity of the diluted product may range between 14" and 22" (Ford Cup 4), preferably between 16" and 20", particularly between 17" and 19".

The paint is applied with a machine velocity ranging from 100 to 150 meters/minute and with a drying temperature ranging from 80 to 110 °C; the application occurs, preferably, at a velocity ranging from 120 to 130 meters/minute.. with a drying temperature ranging from 95 to 105 °C. The amount of paint deposited on the film may range from 0.5 to 2.0 g/m², preferably between 0.8 and 1.4 g/m², particularly between 0.9 and 1.1 g/m².

Acting under the above mentioned conditions it is possible, in particular, to apply the paint directly also on films of polypropylene lacquered with heat-sealing acrylic lakes, avoiding the well known phenomenon of lake attack caused by the alcoholic solvents.

Such attack, beside compromising the sealing properties of the lake, impairs the optical properties of the film, lowering its transparency.

A particularly preferred object of the present invention is therefore the "set" metalization process, according to the steps A), B), C) and D) of printed films of lacquered polypropilene and moreover the so obtained simple or coupled film.

The metalization process of the step C) may be carried out according to the known metalization processes of plastic films in order to obtain a metallic layer having optical density, in the not printed zones, ranging from 1.2 to 2.0, preferably between 1.4 and 1.8 (Theimer Type DDM 4).

The washing with water of the step D) is carried out in a suitable machine allowing the removal of the water-soluble paint and the metal deposited on it, at a velocity ranging from 100 to 150 meters/minute and the drying of the washed film at a temperature ranging from 80 to 120 °C.

The washing is preferably carried out at a velocity ranging from 120 to 130 meters/minute with a drying temperature ranging from 90 to 110 °C. A particularly preferred process is that one in which a paint water-soluble at 33-35% in ethanol is used, having a viscosity ranging from 54" to 56" (Ford Cup 4), which is diluted with ethanol to the achievement of a viscosity equal to 17" - 19", the paint is applied on the plastic film at a velocity equal to 120 m/min with drying temperature ranging from 95 to 105 °C, in order to obtain a basis weight of the paint ranging from 0.9 to 1.1 g/m².

The so obtained film is submitted to a metalization process under vacuum in order to deposit a metallic layer having optical density, in the not printed zones, ranging from 1.6 to 1.8 (Theimer Type DDM 4).

The material is then submitted to a washing step with water carried out at a velocity equal to 120 m/min with drying temperature equal to 90-110 °C. The so obtained film may be used as it is as wrap for containers, for example as external wrap for food containers, or it may be coupled to one or more plastic films and thus to be used, for example, as a wrap in direct contact with the food.

The coupling may be carried out either by the known technologies using solvent adhesives or by the known technologies based on adhesives without solvent.

The use of solvent adhesives is preferred.

The single film or the coupled wrap may then be submitted to further treatments usual in the packaging sector, such as, for example, the application of sealing lacquers or "release" paints.

Examples of plastic films which may be used for the coupling with the partially metalized film are polypropylene, bioriented, co-extruded or lacquered polypropylene, polyester and polyethylene, preferably co-extruded or lacquered polypropylene and polyethylene.

Hereinafter some examples of the process according to the invention are reported. Such examples have only illustrative aim and they do not imply any limitation.

### EXAMPLE 1

### Preparation of a Lacquered Polypropylene Film, Characterized by Transparent Zones and by Zones Printed with Inks and Metalized.

a) A polypropylene film lacquered with an acrylic lake having a thickness equal to 32 micrometers is submitted to a printing process on rotogravure machine, at a velocity equal to 120 meters/min.
   A drawing is printed such that it covers 30% of the film surface applying inks of 7 different colours with a global amount equal to 4.0 g on a squared meter of printed surface.
b) On line, on the remaining 70% of film surface, is then applied a water-soluble paint, based on polyvinyl pyrrolidone "set" with the printed zone, in order to avoid overlaps between the inks and the paint itself.
   The paint is applied after diluting it with ethyl alcohol to the achievement of a viscosity equal to 18" (Ford Cup 4).
   The paint is applied with a drying temperature ranging from 95 to 105 °C in such a way to deposit on the film an amount of 1.0 grams per squared meter of application surface.
   The so obtained film contains residual solvents in amounts ranging from 6 to 9 mg per squared meter of film surface (gas-chromatographic method UNI U59.0B. 162.0, with conditioning at 125 °C for 30 minutes).
c) The film is metalized under vacuum with aluminium in an amount such as to obtain an optical density value in the not printed zone equal to 1.8 (Theimer Type DDM 4).
d) The metalized film is then washed in a water bath in a machine provided with rolls for the sliding of the film at a velocity equal to 120 m/min and with brushes in order to ease the complete removal of the water-soluble paint and the metal deposited on it.

The film is then dried at a temperature ranging from 90 to 110 °C.

The so obtained plastic film shows a printed zone with a drawing covering 30% of the film surface. In this zone the inks turn out to be particularly brilliant and with a marked metallic aspect owing to the presence of the thin aluminium layer superimposed to them.

The remaining not printed area of the film, turns out to be perfectly transparent with no trace of the previously deposited metal. The light transmission of the film (Haze 1.2% - ASTM D 1003) turns out to be substantially equivalent to the light transmission of the film before the process (Haze 1.0% - ASTM D 1003). This points out that the process, notwithstanding the use of ethyl alcohol, is carried out such that it does not damage the lacquered surface of the original film.

The analyses reported below refer to the technical parameters of the obtained film which establish its machinability on the packaging machines or the organoleptic properties and all agree with the requested standards:

| | | |
|---|---|---|
| Film/film Slipperiness (Coefficient of Friction) | = 0.27 | (ASTM D 1894-e) |
| Weldability (Seal Strength) | = 575 g / 25 mm | (130 °C; 2.5 bar; 0.8 sec) |
| Solvent Retention | = 8.2 g / m² | (UNI U59.0B.162.0) |

### EXAMPLE 2

### Preparation of a Lacquered Polypropylene Film, Characterized by Transparent Zones, by Zones Printed with Inks and by Zones Printed with Inks and Metalized.

A film of polypropylene lacquered with acrylic lake having a thickness equal to 32 micrometers is submitted to a printing process on rotogravure machine following the same patterns pointed out in the Example 1 but printing eight colours and creating a drawing such as to cover 50% of the film surface.

On line, the water-soluble paint based on polyvinyl pyrrolidone is then applied at a viscosity equal to 18" (Ford Cup 4) on 80% of the film surface, in such a way to overlap the whole not printed zone and to a portion of the printed zone equal to 30% of the film surface. After metalization with aluminium and subsequent washing with water, the obtained film shows a transparent zone equal to 50% of the film surface, a zone printed with inks covering 30% of the film surface and a zone printed with inks carrying on them a metal layer, equal to 20% of the film surface.

| | | |
|---|---|---|
| Haze (transparent zone) | 1.2% | (ASTM D 1003) |
| Film/film Slipperiness (COF) | 0.28 | (ASTM D 1894-e) |
| Weldability (Seal Strength) | 525 g / 25 mm | (130 °C; 2.5 bar; 0.8 sec) |
| Solvent Retention | 9.5 mg / m² | (UNI U59.0B.162.0) |

### EXAMPLE 3

### Preparation of a Lacquered Polypropylene Film, Characterized by Transparent Zones, by Zones Metalized with Direct Metalization on the Film and by Zones Printed with Inks and Metalized.

A film of polypropylene lacquered with acrylic lake having a thickness equal to 20 micrometers is submitted to the printing process according to the patterns described in the Example 1 but in such a way to obtain an area printed with inks equal to 50% of the film surface and an area of application of the water-soluble paint equal to 10% of the surface of the not printed film, the remaining 40% of film remaining therefore as it is. The metalization process and the subsequent washing, carried out as described in the Example 1, produces a film having a transparent window equal to 10% of the surface, corresponding to the application area of the paint, 50% of area coloured with inks carrying on them the metal and 40% of area directly metalized on the film.

| | | |
|---|---|---|
| Haze (transparent zone) | 1.2% | (ASTM D 1003) |
| Solvent Retention | 9.2 mg / m² | (UNI U59.0B.162.0) |

### EXAMPLE 4

### Preparation of a wrap consisting of two Coupled Lacquered Polypropylene Films, Characterized by Transparent Zones, by Zones Directly Metalized on the Film and by Zones Printed with Inks and Metalized.

The film obtained according to the process described in the Example 3, is coupled to a 20 micrometers lacquered polypropylene film on a coupling machine, applying an amount of adhesive, solvent based, equal to 2.2 grams on a squared meter surface.

Analysis of the so obtained wrap:

| | | |
|---|---|---|
| Film/film COF | 0.32 | (ASTM D 1894-e) |
| Weldability (Seal Strength) | 555 g / 25 mm | (130 °C; 2.5 bar; 0.8 sec) |
| Solvent Retention | 9.5 mg / m² | (UNI U59.0B.162.0) |

### EXAMPLE 5

### Preparation of a Coextruded Polypropylene Film, Characterized by Transparent Zones, by Zones Directly Metalized on the Film and by Zones Printed with Inks and Metalized.

A polypropylene film coextruded by metalization having a thickness equal to 30 micrometers is printed on a rotogravure machine, at 120 meters/minute velocity.

Seven colours are printed in such a way to apply a global amount equal to 4.0 g on a squared meter of printed surface, with a drawing such as to cover 60% of the film surface.

On line, a water-soluble paint based on polyvinyl pyrrolidone is applied on an area equal to 5% of the film surface, positioned in the central zone of the formed article, and on an area equal to 10%, positioned on the borders of the formed article.

The paint is applied after diluting it with ethyl alcohol to the achievement of a viscosity equal to 16" (Ford Cup 4).

The paint is applied with a drying temperature ranging from 90 to 100 °C, in such a way to deposit an amount equal to 1.2 grams per squared meter of application surface.

The so obtained film contains residual solvents in amounts ranging from 7 to 9 mg per squared meter of film surface (gas-chromatographic method UNI U59.0B.162.0, with conditioning at 125 °C for 30 minutes). The subsequent processes of metalization and washing, carried out as described in the Example 1, produce a plastic film characterized by 60% of zone printed with inks and metalized, 25% of zone directly metalized on the film, a transparent window having size equal to 5% of the film surface, and a 10% of transparent area at the external borders of the formed article.

### EXAMPLE 6

### Preparation of a Wrap Consisting of Two Coupled Coextruded Polypropylene Films, Characterized by Transparent Zones, by Zones Directly Metalized on the Film and by Zones Printed with Inks and Metalized.

The film obtained according to the process disclosed in the Example 4, is coupled with a 30 micrometers coextruded polypropylene film on a coupling machine, applying a solvent adhesive in amounts equal to 2.2 g per m² of surface.

Analysis of the so obtained wrap:

| | | |
|---|---|---|
| Film/film COF | 0.33 | (ASTM D 1894-e) |
| Weldability (Seal Strength) | 510 g / 25 mm | (130 °C; 2.5 bar; 0.8 sec) |
| Solvent Retention | 9.7 mg / m² | (UNI U59.0B.162.0) |

## Claims

1. Process for the preparation of printed and partially metallized plastic films, comprising the following steps:
A) a plastic film is printed with inks by a rotogravure machine;
B) to determined zones of the printed plastic film a water-soluble paint is applied by a rotogravure printing machine keeping the paint "set", with a precision equal to two tenths of millimeter, with the inks themselves;
C) the so obtained plastic film is metallized by an under vacuum process, depositing a thin aluminium layer on the whole surface of the printed side of the film;
D) the metallized film is washed with water in order to remove the water-soluble paint and, with it, the metal deposited on it, **characterized in that** said plastic film of step A) is a polypropylene film lacquered with a heat sealing acrylic lake, the water-soluble paint used in step B) contains polyvinylpyrrolidone having a dry residue ranging from 32 to 36% and viscosity between 52 and 58"(Ford cup 4) diluted in an alcoholic solvent so that the viscosity of said water souble paint ranges from 14" to 22" (Ford Cup 4), in step B) the paint is applied with a velocity ranging from 100 to 150 meters/minute and with a drying temperature ranging from 80 to 110°C, and the washing of step D) is carried out in a machine at a velocity from 100 to 150 meters/minute and with a drying temperature ranging from 80 to 120°C.

2. Process as claimed in claim 1, **characterised in that** the water-soluble paint used in step B) is a paint containing synthetic resins in a alcoholic solvent, having viscosity ranging from 17" to 19" (Ford Cup 4).

3. Process as claimed in claim 2, **characterized in that** said alcoholic solvent is selected from the group consisting of methanol, ethanol and isopropanol.

4. Process as claimed in claim 1, **characterized in that** the application of the paint of step B) is carried out with a machine velocity ranging from 120 to 130 meters/minute and with a drying temperature ranging from 95 to 105°C.

5. Process as claimed in claim 1, **characterized in that** the application to the film of the paint of step B) is realized by an amount of paint ranging from 0.8 to 2.0 g/m².

6. Process as claimed in claim 1, **characterized in that** the application to the film of the paint of step B) is realized by an amount of paint ranging from 0.9 to 1.1 g/m².

7. Process as claimed in claim 1, **characterized in that** the metallization of the step C) is carried out in such a way to obtain a metallic layer having optical density, measured in the not printed zones, ranging from 1.2 to 2.0 (Theimer Type DDM4).

8. Process as claimed in claim 1, **characterized in that** the metallization of the step C) is carried out in such a way to obtain a metallic layer having optical density, measured in the not printed zones, ranging from 1.4 to 1.8 (Theimer Type DDM4).

9. Process as claimed in claim 1, **characterized in that** the washing of the step D) is carried out in a machine at a velocity ranging from 120 to 130 meters/minute and with drying of the film washed at a temperature ranging from 90 to 110°C.

## Patentansprüche

1. Verfahren zur Herstellung von gedruckten und teilweise metallisierten Kunststofffolien, welches die folgenden Schritte umfasst:
A) Eine Kunststofffolie wird mittels einer Tiefdruckmaschine mit Druckfarben bedruckt;
B) auf bestimmte Bereiche der bedruckten Kunststofffolie wird mittels einer Tiefdruckmaschine, welche den "Farbensatz" hat, eine wasserlösliche Farbe mit einer Genauigkeit von zwei Zehntel Millimeter zusammen mit den Druckfarben selbst aufgebracht;
C) die so erhaltene Kunststofffolie wird durch einen unter Vakuum ablaufenden Vorgang, bei welchem eine dünne Aluminiumschicht auf der gesamten Fläche der bedruckten Seite der Folie abgeschieden wird, metallisiert;
D) die metallisierte Folie wird mit Wasser gewaschen, um die wasserlösliche Farbe zu entfernen und mit ihr das darauf abgeschiedene Metall, **dadurch gekennzeichnet, dass** die genannte Kunststofffolie des Schrittes A eine Polypropylenfolie ist, welche mit einem heißklebenden Acryllack lackbeschichtet ist, die im Schritt B) benutzte wasserlösliche Farbe Polyvinylpyrrolidon enthält, welches einen Abdampfrückstand im Bereich von 32 bis 36 % und eine Viskosität zwischen 52" und 58" (Fordbecher 4) in Lösung in einem alkoholischen Lösemittel aufweist, so dass die Viskosität der genannten der wasserlöslichen Farbe im Bereich von 14" bis 22" (Fordbecher 4) aufweist, im Schritt B) die Farbe mit einer Geschwindigkeit im Bereich von 100 bis 150 Meter/Minute und bei einer Trocknungstemperatur im Bereich von 80 bis 110 °C aufgetragen wird, und das Waschen des Schritts D) in einer Maschine mit einer Geschwindigkeit von 100 bis 150 Meter/Minute und bei einer Trocknungstemperatur im Bereich von 80 bis 120 °C durchgeführt wird.

2. Verfahren gemäß Anspruch 1, **dadurch gekennzeichnet, dass** die im Schritt B) benutzte wasserlösliche Farbe eine Farbe ist, welche Kunstharze in einem alkoholischen Lösemittel enthält und eine Viskosität im Bereich von 17" bis 19" (Fordbecher 4) hat.

3. Verfahren gemäß Anspruch 2, **dadurch gekennzeichnet, dass** das genannte alkoholische Lösemittel aus einer Gruppe ausgewählt wird, welche aus Methanol, Ethanol und Isopropanol besteht.

4. Verfahren gemäß Anspruch 2, **dadurch gekennzeichnet, dass** die Auftragung der Farbe gemäß Schritt B) mit einer Maschinengeschwindigkeit, welche im Bereich von 120 bis 130 Meter/Minute liegt, und bei einer Trocknungstemperatur im Bereich von 95 bis 105 °C ausgeführt wird.

5. Verfahren gemäß Anspruch 1, **dadurch gekennzeichnet, dass** die Auftragung der Farbe gemäß Schritt B auf die Folie mit einer Farbmenge ausgeführt wird, die im Bereich von 0,8 bis 2,0 g/m² liegt.

6. Verfahren gemäß Anspruch 1, **dadurch gekennzeichnet, dass** die Auftragung der Farbe gemäß Schritt B auf die Folie mit einer Farbmenge ausgeführt wird, die im Bereich von 0,9 bis 1,1 g/m² liegt.

7. Verfahren gemäß Anspruch 1, **dadurch gekennzeichnet, dass** die Metallisierung gemäß Schritt C) auf eine derartige Weise ausgeführt wird, dass man eine Metallschicht erhält, die eine optische Dichte im Bereich von 1,2 bis 2,0 (DDM4 vom Theimer-Typ) aufweist, gemessen in den nicht bedruckten Bereichen.

8. Verfahren gemäß Anspruch 1, **dadurch gekennzeichnet, dass** die Metallisierung gemäß Schritt C) auf eine derartige Weise ausgeführt wird, dass man eine Metallschicht erhält, die eine optische Dichte im Bereich von 1,4 bis 1,8 (DDM4 vom Theimer-Typ) aufweist, gemessen in den nicht bedruckten Bereichen.

9. Verfahren gemäß Anspruch 1, **dadurch gekennzeichnet, dass** das Waschen gemäß Schritt D) von einer Maschine mit einer Geschwindigkeit im Bereich von 120 bis 130 Meter/Minute und bei einer Trocknung der gewaschenen Folie bei einer Temperatur im Bereich von 90 bis 110 °C ausgeführt wird.

## Revendications

1. Procédé de préparation de films plastiques imprimés et partiellement métallisés, le procédé comprenant les étapes suivantes consistant à:
A) imprimer un film plastique avec des encres à l'aide d'un appareil de rotogravure;
B) appliquer sur des zones déterminées du film plastique imprimé une peinture soluble dans l'eau à l'aide d'un appareil d'impression par rotogravure en maintenant la peinture pendant qu'elle sèche, avec une précision égale à deux dixièmes de millimètre, avec les encres elles-mêmes;
C) métalliser le film plastique ainsi obtenu par un processus sous vide, en déposant une mince couche d'aluminium sur la totalité de la surface du côté imprimé du film;
D) laver le film métallisé avec de l'eau afin de retirer la peinture soluble dans l'eau et, avec elle, le métal déposé sur celui-ci; **caractérisé en ce que** ledit film plastique de l'étape A) est un film de polypropylène laqué avec une laque acrylique polymérisant à la chaleur, la peinture soluble dans l'eau utilisée à l'étape B) contient du polyvinylpyrrolidone ayant un résidu sec compris dans une plage allant de 32% à 36% et une viscosité comprise entre 52" et 58" (coupe de Ford N° 4) dilué dans un solvant alcoolique, de sorte que la viscosité de ladite peinture soluble dans l'eau est comprise dans une plage allant de 14" à 22" (coupe de Ford N° 4); à l'étape B) la peinture est appliquée à une vitesse comprise dans une plage allant de 100 à 150 mètres/minutes et à une température de séchage comprise dans une plage allant de 80 °C à 110 °C; et le nettoyage de l'étape D) est exécuté dans une machine à une vitesse comprise dans une plage allant de 100 à 150 mètres/minutes et à une température de séchage comprise dans une plage allant de 80 °C à 120 °C.

2. Procédé selon la revendication 1, **caractérisé en ce que** la peinture soluble dans l'eau utilisée à l'étape B) est une peinture contenant des résines synthétiques dans un solvant alcoolique ayant une viscosité comprise dans une plage allant de 17" à 19" (coupe de Ford N° 4).

3. Procédé selon la revendication 2, **caractérisé en ce que** ledit solvant alcoolique est sélectionné à partir du groupe comprenant du méthanol, de l'éthanol et de l'alcool d'isopropyle.

4. Procédé selon la revendication 1, **caractérisé en ce que** l'application de la peinture de l'étape B) est exécutée à une vitesse machine comprise dans une plage allant de 120 à 130 mètres/minutes et à une température de séchage comprise dans une plage allant de 95 °C à 105 °C.

5. Procédé selon la revendication 1, **caractérisé en ce que** l'application, sur le film, de la peinture de l'étape B) est exécutée avec une quantité de peinture comprise dans une plage allant de 0,8 à 2,0 g/m².

6. Procédé selon la revendication 1, **caractérisé en ce que** l'application, sur le film, de la peinture de l'étape B) est exécutée avec une quantité de peinture comprise dans une plage allant de 0,9 à 1,1 g/m².

7. Procédé selon la revendication 1, **caractérisé en ce que** la métallisation de l'étape C) est exécutée de telle manière que l'on obtient une couche métallique ayant une densité optique, mesurée dans les zones qui ne sont pas imprimées, comprise dans une plage allant de 1,2 à 2,0 (Theimer Type DDM4).

8. Procédé selon la revendication 1, **caractérisé en ce que** la métallisation de l'étape C) est exécutée de telle manière que l'on obtient une couche métallique ayant une densité optique, mesurée dans les zones qui ne sont pas imprimées, comprise dans une plage allant de 1,4 à 1,8 (Theimer Type DDM4).

9. Processus selon la revendication 1, **caractérisé en ce que** le nettoyage de l'étape D) est exécuté dans une machine à une vitesse comprise dans une plage allant de 120 à 130 mètres/minutes et avec un séchage du film lavé à une température comprise dans une plage allant de 90 °C à 110 °C.
